# EUROPÄISCHE PATENTSCHRIFT

(11) **EP 0 526 455 B1**
(45) Veröffentlichungstag und Bekanntmachung des Hinweises auf die Patenterteilung: **08.06.1994**
(21) Anmeldenummer: 91903423.1
(22) Anmeldetag: 13.02.1991
(51) Int. Cl.: H05K 3/28, B29C 41/18, B29C 41/20, B07C 3/18

(54) **VERFAHREN ZUM AUFBRINGEN EINER KUNSTSTOFFSCHUTZSCHICHT SOWIE VORRICHTUNG ZUR DURCHFÜHRUNG DES VERFAHRENS**
PROCESS FOR APPLYING A PROTECTIVE PLASTIC FILM, AND A DEVICE FOR CARRYING OUT THE PROCESS
PROCEDE DE DEPOT D'UNE COUCHE PROTECTRICE EN MATIERE PLASTIQUE ET DISPOSITIF POUR L'EXECUTION DE CE PROCEDE

(30) Priorität: 23.04.1990 DE 4012903
(43) Veröffentlichungstag der Anmeldung: 10.02.1993
(73) Patentinhaber: Klingel, Wolfgang, D-71292 Friolzheim (DE)
(72) Erfinder: Klingel, Wolfgang, D-71292 Friolzheim (DE)
(74) Vertreter: Lutz, Johannes Dieter, Dr.
(86) Internationale Anmeldenummer: EP9100280
(87) Internationale Veröffentlichungsnummer: WO9116806

(56) Entgegenhaltungen:
- DE-A- 2 848 569
- US-A- 3 853 663
- US-A- 4 794 018

## Beschreibung

Die Erfindung betrifft ein Verfahren zum Aufbringen einer Kunststoffschutzschicht auf eine mindestens einseitig mit elektronischen Bauelementen bestückte Leiterplatte gemäß dem Oberbegriff des Patentanspruchs 1 sowie eine zur Durchführung dieses Verfahrens geeignete Vorrichtung.

Um elektronische Bauelemente, die in gängiger Technik einseitig auf Leiterplatten mit vorgefertigten - aufgedruckten - Leiterbahnen angeordnet sind, gegen vielfältige Einflüsse zu schützen, z.B. gegen Korrosion, ist es bekannt, diese Bauelemente und die sie tragenden Teile der Leiterplatten mit einem isolierenden Lack zu beschichten, der auch die auf die Leiterplatte aufgedruckten Leiterbahnen gegen Kurzschlüsse sichert, die durch Verschmutzung bedingt sein können.

Derartige Beschichtungen können im sogenannten Tauchverfahren hergestellt werden, wobei dann allerdings Flächenbereiche, die nicht beschichtet werden dürfen, z.B. Flächenbereiche, innerhalb derer freiliegende Leiter vorhanden sein müssen, um den Kontakt zu weiteren Leiterplatten oder Versorgungsanschlüssen zu ermöglichen, in aufwendigen Klebevorgängen abgedeckt werden müssen.

Diese Vorgehensweise ist zeitraubend und daher kostenintensiv. Dasselbe gilt, wenn die Leiterplatten durch Aufbringen des Isolier-Lackes mit einem Pinsel beschichtet werden, was zwar dann noch rationell sein mag, wenn die Leiterplatten sehr klein sind und/oder nur kleine oder sehr kompliziert gestaltete Bereiche beschichtet werden müssen, d.h. in Sonderfällen und allenfalls bei kleinen Serien.

Zum vorgenannten Zweck ist es auch bekannt, Koordinaten-gesteuerte Beschichtungsvorrichtungen einzusetzen, welche die Beschichtung zeilenweise auftragen, sei es durch Aufgießen oder durch Aufsprühen. Derartige Vorrichtungen sind jedoch nicht nur teuer, sondern arbeiten auch wegen des zeilenweisen Aufbringens der Beschichtung relativ langsam, mit der Folge, daß ihr Einsatz, ungeachtet der errreichbaren Automation des Beschichtungsvorganges, gleichwohl teuer ist.

Eine zusammenfassende Darstellung möglicher Beschichtungsverfahren ist in der Puplikation von Peter A. Knödel, "Die Schutzlackierung von bestückten Leiterplatten", Metalloberfläche, 1989/4 + 5 gegeben.

Zu diesen bekannten Verfahren ist auch das aus der US-PS 4,794,018 bekannte Verfahren zu rechnen, bei dem zu beschichtende Leiterplatten von einem durch eine flache Wanne geleiteten Strom von flüssigem Beschichtungsmaterial angeströmt werden, der mittels einer Pumpe erzeugt wird, die das Beschichtungsmaterial von einem Vorratsbehälter aus in die Wanne fördert, von der aus das Beschichtungsmaterial in einen tiefer gelegenen Auffangbehälter abströmen kann. Je nach der Eintauchtiefe der Leiterplatten kann dabei sowohl ihre Unterseite als auch ihre Oberseite beschichtet werden. Randbereiche, die nicht beschichtet werden sollen, sind außerhalb von Wandausnehmungen der Wanne angeordnet, über die das Beschichtungsmaterial in den Auffangbehälter abströmen kann. Nach diesem Verfahren ist es praktisch nicht möglich, innere Bereiche der Platten, die von zu beschichtenden Bereichen umschlossen sind, von der Beschichtung auszunehmen.

Weitere Beschichtungsverfahren, mittels derer definiert begrenzte Bereiche von Körpern beschichtbar sind, sind durch die DE-OS 28 48 569 und durch die US-PS 3,853,663 bekannt.

Das Verfahren nach der DE-OS 28 48 569 dient zum Beschichten von Keramik- oder Porzellangegenständen wie Kannen, Vasen oder dergleichen mit Glasur-Material, bei denen mit Ausnahme eines kreisringförmigen, schmalen, unteren äußeren Randes ihres Bodens der in seinem zentralen Bereich etwas konkav nach innen gewölbt ist, sämtliche Oberflächenbereiche glasiert werden müssen. Der Behälter wird auf eine nachgiebige Platte gestellt, die den Innraum eines Vorratsbehälters für Glasur-Material abdeckt, jedoch eine Öffnung hat, über die der Innenraum des Behälters mit dem durch den gewölbten Boden begrenzten, flach konkav gewölbten Raum der durch die Standfläche berandet ist, kommuniziert. Durch Unterdruckbeaufschlagung des von dem Glasurmaterial nicht erfüllten Innenraum des Vorratsbehälter wird der Gegenstand an die nachgiebige Unterlage gedrückt. Durch Schwenken des Vorratsbehälters und des an diesem solchermaßen festgehaltenen Gegenstandes wird der Bodenbereich innerhalb der Standfläche glasiert. Durch Eintauchen des Gegenstandes mit dem noch an diesem befestigten Vorratsbehälter in einen weiteren Vorratsbehälter, der mit Glasurmaterial verfüllt ist, wir die übrige Oberfläche des Gegenstandes glasiert, die durch dessen äußere und innere Mantelfläche und die Innenseite seines Bodens gebildet wird.

Das durch die US-PS 3,853,663 bekannte Verfahren dient zur Beschichtung kreisringförmiger Stirnflächen von Tennisballhälften mit flüssigem Klebstoff, die die Form von Kugel-Halbschalen haben, die nachdem ihre kreisringförmigen Stirnflächen beschichtet sind, aneinandergepreßt werden, um einen stofflüssig fest verbundenen Kugelschalenkern zu erzielen. Die zu beschichtende Ballhälfte wird dabei oberhalb des Flüssigkeits-Spiegels des in einem Behälter angeordneten Klebstoffes so angeordnet, daß die für die Verklebung dienende Ringfläche in einem kleinen Abstand von diesem Spiegel angeordnet ist. In dem Behälter ist, unterhalb des Flüssigkeitsspiegels, ein Ring angeordnet, dessen mittlerer Durchmesser dem mittleren Durchmesser der zu beschichtenden Fläche entspricht. Durch Anheben dieses Ringes wird zwischen diesem und der zu beschichtenden Ringfläche gleichsam eine ringförmige Welle aus Beschichtungsmaterial erzeugt, die die Ringfläche der Ballhälfte erreicht und diese benetzt. Dieses Verfahren dient dazu, sicherzustellen, daß nur der ringförmige Rand der Ballhälften beschichtet wird, nicht aber auch äußere Bereiche der Ballhälften, was deren weitere Behandlung erschweren würde. Nach diesem Verfahren können allenfalls "linienförmige" Bereiche miteinander zu verbindender Körper beschichtet werden, nicht aber flächenhafte Bereiche, die relativ große Querschnittsflächen haben.

In anbetracht der vorerwähnten Nachteile bekannter Beschichtungsverfahren ist es zunächst Aufgabe der Erfindung, ein Verfahren der eingangs genannten Art anzugeben, das eine rationelle und zuverlässige Beschichtung auch kompliziert gestalteter Beschichtungsflächen von Leiterplatten ermöglicht, sowie eine Vorrichtung zur Durchführung des Verfahrens.

Diese Aufgabe wird hinsichtlich des Verfahrens durch die kennzeichnenden Merkmale des Patentanspruchs 1 gelöst.

Hieraus resultierende Vorteile des erfindungsgemäßen Verfahrens sind zumindest die folgenden:

Es ist mit Taktzeiten durchführbar, die wesentlich kürzer sind als die beispielsweise mit Koordinaten-Vergußmaschinen oder dergleichen erreichbaren Taktzeiten. Es ist sowohl für Leiterplatten anwendbar, die mit relativ hochbauenden elektronischen Bauelementen bestückt sind als auch für Leiterplatten, die mit nur relativ flachbauenden elektronischen Bauelementen bestückt sind, da der senkrecht zur Beschichtungs-Grundfläche gemessene Beschichtungsbereich sehr einfach durch geeignete Wahl der Tiefe einstellbar ist, mit der der Trog mit Beschichtungsmaterial verfüllt wird.

Die Qualität der Beschichtung ist sehr gut, da keinerlei "Schattenkanten" auftreten und z.B. auf Anschlußbeinen stehende Bauelemente allseitig von dem Beschichtungsmaterial umschlossen und benetzt werden können. Es wird eine Qualität der Beschichtung erzielt, die einer im gängigen Tauchverfahren erzielbaren Qualität entspricht.

Das Verfahren ist für die Leiterplatten hinreichend schonend, um Beschädigungen derselben zuverlässig auzuschließen.

Hinsichtlich der Vorrichtung wird die eingangs genannte Aufgabe durch die Merkmale des Anspruchs 2 gelöst, durch die ihrem grundsätzlichen Aufbau nach eine zur Durchführung des erfindungsgemäßen Verfahrens geeignete, einfache Vorrichtung umrissen ist.

Für diese Vorrichtung sind durch die Merkmale der Ansprüche 3 bis 5 alternative Gestaltungen angegeben, die je nach Betriebsart der Vorrichtung und/oder Konsistenz des Beschichtungsmaterials von besonderem Vorteil sind.

In der Gestaltung der Vorrichtung gemäß Anspruch 3 kann das Beschichtungsmaterial, wenn der Trog hinreichend schnell geschwenkt wird, durch die Fliehkraft am Trogboden gehalten werden, so daß es erst auf die Leiterplatte herabfließt, - "fällt" - wenn die Schwenkbewegung beendet ist, wobei in dieser Gestaltung der Vorrichtung der Rahmen mit dem Trog nach oben geschwenkt wird.

In der gemäß Anspruch 4 vorgesehenen Gestaltung der Vorrichtung kann die Fliehkraft, die beim Schwenken des Troges auftritt, dazu ausgenützt werden, das Beschichtungsmaterial gleichsam gegen die Leiterplatte zu schleudern und so den Beschichtungsvorgang zu beschleunigen,. wobei in dieser Gestaltung der Vorrichtung der Rahmen mit dem Trog nach unten geschwenkt wird.

Die gemäß Anspruch 5 vorgesehene Gestaltung der Vorrichtung ist Fliehkraft-neutral und hat den Vorteil, daß der für das Schwenken der Vorrichtung benötigte Raumbedarf minimal ist.

Eine gemäß Anspruch 6 zur Fixierung der Leiterplatte an der Oberseite der Lochplatte des schwenkbaren Maschinenrahmens vorgesehene Zuhalteplatte kann an beidseits der Öffnung der Lochplatte angeordneten Bolzen senkrecht zur Jochplatte verschiebbar geführt und mittels einer federelastischen Spannvorrichtung in der Zuhalte-Stellung fixierbar sein.

In der gemäß Anspruch 7 vorgesehenen Gestaltung der Zuhalteplatte mit einem der Lötseite der Leiterplatte zugewandten Druckkissen ist es möglich, eine beidseitige Beschichtung der Leiterplatte in einem einzigen Arbeitstakt zu erzielen.

In Kombination hiermit ist die durch die Merkmale des Anspruchs 8 angegebene Gestaltung und Anordnung der Zuhalteplatte besonders vorteilhaft, damit im aufgeklappten Zustand der Zuhalteplatte ein bequemes Tränken des Druckkissens möglich und auch insoweit ein günstig kurzer Arbeitstakt gewährleistet ist.

Weitere Einzelheiten und Merkmale der Erfindung ergeben sich aus der nachfolgenden Beschreibung eines Ausführungsbeispiels anhand der Zeichnung. Es zeigen:
- Fig. 1: eine schematisch vereinfachte Seitenansicht einer erfindungsgemäßen Vorrichtung zum Aufbringen einer Kunststoffschicht auf die mit Bauelementen bestückte Seite einer Leiterplatte mit einem schwenkbaren Rahmen, an dem auf- und ab-verfahrbar ein zur Aufnahme des Beschichtungsmaterials in flüssigem Zustand vorgesehener Trog angeordnet ist, der mit den freien Rändern seiner Mantel-Stirnflächen an die Leiterplatte andrückbar ist,
- Fig. 2: den Trog gemäß Fig. 1 in Draufsicht und
- Fig. 3: eine perspektivische Ansicht des Troges gemäß Fig. 2 und einer mit diesem beschichtbaren Leiterplatte.

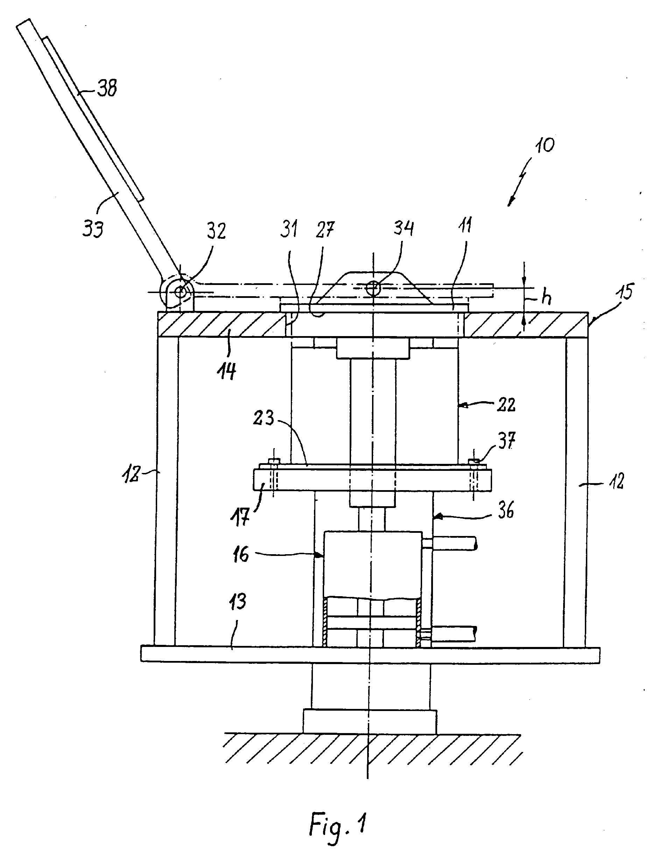

Die in der Fig. 1, auf deren Einzelheiten zunächst verwiesen sei, dargestellte, erfindungsgemäße, insgesamt mit 10 bezeichnete Vorrichtung zum Aufbringen isolierender Schichten, z.B. Lackschichten auf die mit elektronischen Bauelementen bestückte Seite einer Leiterplatte 11, ist dem Bauprinzip nach in der Art einer Presse ausgebildet, die als Pressenrahmen 15 eine über Ständersäulen 12 mit einer Grundplatte 13 fest verbundene Jochplatte 14 umfaßt, welche im Abstand von der Grundplatte 13, parallel zu dieser - in der dargestellten Funktionslage horizontal - verläuft.

Zwischen der Jochplatte 14 und der Grundplatte 13 ist ein beim dargestellten Ausführungsbeispiel als pneumatischer Zylinder 16 ausgebildeter Hub-Antrieb als "Pressen"-Antrieb vorgesehen, mittels dessen eine Tragplatte 17, welche ihrerseits parallel zu der Jochplatte 14 und der Grundplatte 13 verläuft, zwischen der Grundplatte 13 und der Jochplatte 14 anhebbar und absenkbar ist.

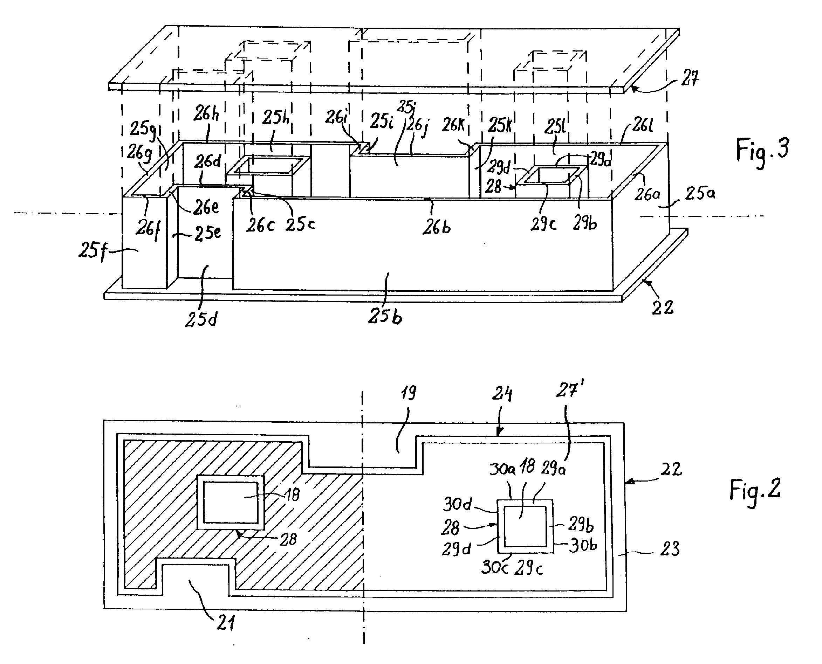

Für die Leiterplatte 11 wird vorausgesetzt, daß diese nur auf Teilbereichen ihrer mit elektronischen Bauelementen bestückten Seite mit einem isolierenden Lack beschichtet werden soll, wobei z.B. inselförmige Bereiche 18 und/oder Randbereiche 19 und 21 der Leiterplatte 11, wie am besten der Fig. 2 entnehmbar beschichtungsfrei bleiben sollen.

Um dies zu ermöglichen, ist als funktionswesentliches Element der Vorrichtung 10 ein insgesamt mit 22 bezeichneter Trog vorgesehen, der einen flach-plattenförmigen Boden 23 und einen an diesen dicht angesetzten Trogmantel 24 hat, der beim dargestellten Ausführungsbeispiel ebenso wie der Trogboden 23 als aus dünnwandigem Blech bestehend vorausgesetzt wird und an den Trogboden 23 angelötet oder angeschweißt ist.

Der Trogmantel 24 ist als Biegeteil aus einem in praxi zwischen 4 und 10 cm breiten Blechstreifen hergestellt, der sehr genau parallel zueinander verlaufende Ränder hat. Er ist so ausgebildet, daß, in Höhe der gemäß der Darstellung der Fig. 3 oberen, schmalen Stirnflächen 26a bis 261 der beim dargestellten Ausführungsbeispiel abschnittsweise geradlinig verlaufenden Außenwandabschnitte 25a bis 251 des Trogmantels 24 gesehen, deren innere Ränder entlang der Außenkontur der zu beschichtenden Fläche 27 der Leiterplatte 11 verlaufen.

Beim dargestellten Ausführungsbeispiel, bei dem der Trogmantel 24 senkrecht auf der Bodenplatte 23 des Troges 22 steht, entspricht dieser Beschichtungsfläche 27 der Leiterplatte 11 die von dem Trogmantel 24 umschlossene innere Bodenfläche 27′ des Troges 22. Die beschichtungsfrei zu haltenden inselförmigen Bereiche 18 der Leiterplatte 11 sind gemäß der Darstellung der Fig. 2 und 3 durch vom Boden 27′ des Troges 22 ebenfalls senkrecht aufragende "Kamine" ausgeschlossen, wobei die oberen schmalen Stirnflächen 29a bis 29d der wiederum abschnittsweise geradlinig verlaufenden Kaminwandabschnitte 30a bis 30d koplanar mit den oberen schmalen Stirnflächen 26a bis 261 der beim dargestellten Ausführungsbeispiel rechtwinklig aneinander anschliessenden Mantelwandbreiche 25a bis 251 verlaufen.

Die Jochplatte 14 der Vorrichtung 10 ist mit einer in der Regel rechteckigen Öffnung 31 versehen, deren lichte Länge und Breite dahingehend gewählt ist, daß der Trog 22 mit seinem oberen Mantelbereich mit genügendem lichtem Abstand von den Längsund Querbegrenzungen dieser Öffnung 31 in diese eingeführt und mit seinen Mantelstirnflächen 26a bis 261 bis in Anlage mit der Leiterplatte 11 gebracht werden kann, welche ihrerseits mit Randabschnitten an den Längs- und/oder Querrändern der Jochplatte 14 abgestützt gehalten ist. Des weiteren ist an dem Rahmen 15, beim dargestellten Ausführungsbeispiel an der Oberseite der Jochplatte 14 um eine horizontale Achse 32 schwenkbar eine Zuhalteplatte 33 gelagert, mittels derer die zu beschichtende Leiterplatte 11 mit einer Mindest-Zuhaltekraft in Anlage mit der Jochplatte 14 des Maschinenrahmens 15 gehalten werden kann.

Dieser die Grundplatte 13 und die Jochplatte 14 sowie die diese miteinander verbindenen Säulen 12 umfassende Maschinenrahmen 15 ist seinerseits um eine horizontale Achse 34 schwenkbar an einem lediglich schematisch angedeuteten, feststehenden Maschinengestell 36 gelagert, wobei die Schwenkachse 34 beim dargestellten Ausführungsbeispiel in vertikalem Abstand h von der Oberseite der Jochplatte 14 verläuft.

Die insoweit erläuterte Vorrichtung 10 wird zum Aufbringen der isolierenden Beschichtung auf die mit den Bauelementen bestückte Seite der Leiterplatte 11 wie folgt benutzt, wobei anhand der Beschreibung dieser Benutzung auch das erfindungsgemäße Beschichtungsverfahren erläutert wird, das ebenfalls Gegenstand der Erfindung ist.

In der abgesenkten Position der Tragplatte 17 und des z.B. mittels Schrauben 37 an dieser befestigen Troges 22 wird in diesen eine Menge an flüssigem Beschichtungsmaterial, z.B. ein Acryl- oder ein Polyurethan-Lack eingebracht, welche ausreicht, einige hundert Leiterplatten zu beschichten. In praxi bedeutet dies, daß der Trog 22 auf einer Tiefe von 2 cm mit dem Isolier-Lack verfüllt wird. Die benötigte Tiefe richtet sich natürlich nach der Bauhöhe der insgesamt zu beschichtenden Bauelemente und der Zahl der zu beschichtenden Leiterplatten 11.

Nachdem der Trog 22 solchermaßen mit dem Beschichtungsmaterial verfüllt ist, wird die Leiterplatte 11 in einer z.B. durch Anschläge exakt definierten Position mit der Beschichtungsseite nach unten über die Öffnung 31 der Jochplatte 14 gelegt, wobei die Justierung der Leiterplatte 11, einerseits, und die Fixierung des Troges 22 an der Tragplatte 17, andererseits, derart aufeinander abgestimmt sind, daß wenn der Trog 22 angehoben wird, die oberen freien Stirnflächen 26a bis 261 des Trogmantels 24 exakt die zu beschichtenden Flächenbereiche der Leiterplatte 11 umschließen.

Nach dem Auflegen der Leiterplatte 11 auf die Jochplatte 14 wird die Zuhalteplatte 33 in ihre Schließ-Position gebracht, in der sie die Leiterplatte 11 sicher an der Jochplatte 14 in Anlage mit dieser hält und in dieser Schließ-Position fixiert. Eine diesbezüglich vorgesehene Verriegelungseinrichtung ist, der Einfachheit halber, nicht dargestellt.

Danach wird - durch Aktivierung des Hub-Antriebes 16 - der Trog 22 angehoben und mit einer, beim dargestellten, speziellen Ausführungsbeispiel z.B. durch ein nicht dargestelltes Druckbegrenzungsventil begrenzten Kraft mit den oberen, schmalen Stirnflächen 26a bis 261 seines Trogmantels 24 in Anlage mit der zu beschichtenden Fläche der Leiterplatte 11 gedrängt. Diese bildet nun - in dieser Position - gleichsam einen den Trog 22 abschließenden Deckel.

Hiernach wird der Maschinenrahmen 15 um die horizontale Achse 34 um 180° - nach oben - geschwenkt, so daß nunmehr für eine Zeitspanne definierter - kurzer -Dauer die Leiterplatte 11 den Trogboden bildet, wobei in dieser Position das Beschichtungsmaterial in benetzenden Kontakt mit der zu beschichtenden Fläche der Leiterplatte gelangt, und wobei nunmehr die von der durch die Leiterplatte 11 gebildeten Bodenplatte des Troges aufragenden Bauelemente innerhalb der Tiefe der Beschichtungsflüssigkeit benetzt werden, die natürlich, wenn eine die Bauelemente vollständig einhüllende Beschichtung erforderlich ist, die dafür erforderliche hinreichende Tiefe haben muß.

Nach der genannten Zeitspanne, die in praxi nur wenige Zehntel Sekunden beträgt, wird der schwenkbare Rahmen 15 in die in der Fig. 1 dargestellte Grundstellung zurückgeschwenkt, in der überschüssiges Beschichtungsmaterial von der Leiterplatte 11 abtropfen kann.

Dieses Abtropfen kann auch dadurch erleichtert werden, daß der Maschinenerahmen 15, bevor er in die in der Fig. 1 dargestellte, horizontalem Verlauf des Trogbodens 23 wieder entsprechende Position geschwenkt wird, zuvor für einige Sekunden in einer Position gehalten wird, in der der Trogboden 23 und demgemäß auch der Trogmantel 24 schräg, z.B. unter 45° geneigt, verlaufen, wodurch das Abtropfen und Abfließen der Beschichtungsflüssigkeit von der Leiterplatte 11 und von der Innenseite des Trogmantels 24 beschleunigt werden kann. In bevorzugter Gestaltung der Vorrichtung 10 ist an der mit der Außenseite der Leiterplatte, der sogenannten Lötseite in Anlage kommenden Seite der Zuhalteplatte 33 ein Druckkissen 38 angeordnet, mittels dessen - im Druckverfahren - die Lötseite der Leiterplatte 11 mit isolierendem Lack beschichtbar ist.

Dieses Druckkissen 38 kann, während die Vorrichtung zum Abnehmen der Leiterplatte 11 "geöffnet", d.h. die Zuhalteplatte 33 in ihre - horizontale - Offen-Stellung geschwenkt ist, bequem mit dem Beschichtungsmaterial getränkt werden.

In weiterer, nicht eigens dargestellter Gestaltung der Vorrichtung 10 kann diese auch dahingehend abgewandelt sein, daß der Trogmantel 24 als selbständiges Funktionselement ausgebildet ist, d.h. nicht mit einem fest mit dem Mantel 24 verbundenen Boden versehen ist, wobei dann die Vorrichtung 10 in der Weise gestaltet und benutzt wird, daß der Trogmantel 24 an einer schwenkbaren Halterung sitzt und die Leiterplatte von einer freien Seite, z.B. von oben her an den Trogmantel 24 mit einer Mindestkraft andrückbar und in dieser Position fixierbar ist, wonach dann die Leiterplatte 11 zusammen mit dem Trogmantel 24 in eine Position schwenkbar ist, in welcher von oben her mittels einer Befüll-Vorrichtung das Beschichtungsmaterial in diesen Trog einfüllbar ist, welcher danach durch "Ausleeren" des überschüssigen Beschichtungsmaterials in einen Vorratsbehälter entleerbar ist, wonach die beschichtete Leiterplatte zweckmäßigerweise aus einer Positio, in der sie an der Oberseite des zu dem Vorratsbehälter nach unten hin offenen Trogmantels 24 angeordnet ist, von dem Trogmantel 24 abgenommen werden kann. In dieser Gestaltung hat die erfindungsgemäße Vorrichtung 10 den Vorzug, daß pro Arbeitstakt nur relativ wenig Beschichtungsmaterial in den durch den Mantel 24 und die Leiterplatte 11 gebildeten Trog eingefüllt werden muß, was gegebenenfalls durch Druck unterstützt werden kann.

Anderseits ist der apparative Aufwand insgesamt gesehen größer als bei der als Ausführungsbeispiel erläuterten und dargestellten Vorrichtung 10.

Es versteht sich, daß der Trog 22 nicht aus Blech hergestellt sein muß, sondern auch aus Kunststoffteilen hergestellt sein kann, die durch Kleben oder Schweißen fest miteinander verbunden sind.

Weiter versteht es sich, daß anstelle eines pneumatischen Hubantriebes 16 auch ein hydraulischer oder ein von Hand betätigbarer, federnd abgestützter, mechanischer Extender-Antrieb vorgesehen sein könnte, der ein Andrücken des Trogmantels 24 an die Leiterplatte 11 mit definierter Kraft ermöglicht.

## Patentansprüche

1. Verfahren zum Aufbringen einer Kunststoff-Schutzschicht auf eine mindestens einseitig mit elektronischen Bauelementen bestückte Leiterplatte, auf der auch mit solchen Bauelementen bestückte Bereiche vorhanden sind, die beschichtungsfrei zu halten sind, z.B. für Steckeranschlüsse und Relais, mit einem Trog, in den in flüssigem Zustand befindliches Beschichtungsmaterial eingebracht wird, mit dem die zu beschichtende(n) Fläche(n) der Leiterplatte in benetzenden Kontakt gebracht wird, wonach die solchermaßen benetzte und flächenhaft beschichtete Leiterplatte einem Trocknungsvorgang ausgesetzt wird, in dem die Beschichtung aushärtet, **da****durch gekennzeichnet,** daß ein Trogmantel (24) hergestellt wird, bei dem die freien Stirnflächen (26a bis 26l) seiner Mantelwände (25a bis 25l) bzw. Mantelwandabschnitte einen dem Umriß der zu beschichtenden Fläche(n) entsprechenden Verlauf haben und in einer Ebene oder Fläche verlaufen, die nach ihrer Verlaufsform derjenigen Ebene oder Fläche entspricht, in der die Konturen der zu beschichtenden Fläche(n) verlaufen, daß die Leiterplatte (11) mit ihrer teilweise zu beschichtenden Seite nach innen weisend an den koplanar angeordneten freien Stirnflächen (26a bis 26l) zur Anlage gebracht und an diesen entsprechend dem Konturenverlauf der Beschichtungsfläche(n) angedrückt gehalten wird und danach der Trogmantel (24) und die an diesen angesetzte Leiterplatte (11) in eine Position gebracht werden, in der die Leiterplatte (11) den Boden des Troges (22) bildet und in den Trog (22) eingebrachtes Beschichtungsmaterial die Beschichtungsflächen benetzend sich über diese ausbreiten kann, und daß hiernach der Trog (22) mit noch angesetzter Leiterplatte (11) in eine Position gebracht wird, in der überschüssiges Beschichtungsmaterial von der Leiterplatte (11) abfließt und abtropft und diese hiernach abgenommen und dem Trocknungs- bzw. Aushärtungsvorgang unterworfen wird.

2. Vorrichtung zum Aufbringen einer Kunststoffschicht auf eine mindestens einseitig mit elektronischen Bauelementen bestückte Leiterplatte, auf der auch mit solchen Bauelementen bestückte Bereiche vorhanden sind, die beschichtungsfrei zu halten sind, z.B. für Steckeranschlüsse und Relais, mit einem Trog, in den in flüssigem Zustand befindliches Beschichtungsmaterial einbringbar ist, mit dem die zu beschichtende(n) Fläche(n) der Leiterplatte in benetzenden Kontakt bringbar ist/sind, insbesondere zur Durchführung des Verfahrens nach Anspruch 1, **gekennzeichnet durch,** folgende Merkmale:
a) Der Trog (22) umfaßt ein plattenförmiges Bodenteil (23), von dem Trogwand-Abschnitte (25a bis 25l) sowie Kaminwandabschnitte (30a bis 30d) zur Umgrenzung beschichtungsfreier inselförmiger Bereiche (18) der Leiterplatte (11) vorgesehener Kamine (28) senkrecht aufragen;
b) der Trog (22) ist mit seiner Bodenplatte (23) in definierter Position an einer Tragplatte (17), die Teil der Vorrichtung ist, festlegbar, die mit parallelem Verlauf zu einer Grundplatte (13) und einer Jochplatte (14) , die im Abstand voneinander angeordnet, fest miteinander zu einem Rahmen (15) verbunden sind, zwischen diesen angeordnet und senkrecht zu diesen hin- und herverschiebbar ist;
c) die Jochplatte (14) ist mit einer Öffnung (31) versehen, an deren Rändern die Leiterplatte (11) in definierter Position mit zu dem Trog (22) hinweisender Beschichtungsseite fixierbar ist, derart, daß die Konturen ihrer zu beschichtenden Fläche(n) deckungsgleich mit den inneren Rändern der freien Stirnflächen 26a bis 26l) der den Trogmantel (24) bildenden Mantelwandabschnitte (25a bis 25l) angeordnet sind;
d) der Rahmen (15) ist um eine horizontale Achse (34) schwenkbar an einem Maschinengestell (36) gelagert, wobei der Schwenkwinkel, bezogen auf eine Grundstellung des Rahmens (15), in der dessen Grundplatte (13) horizontal verläuft und unterhalb der Tragplatte (17) angeordnet ist, mindestens 180° beträgt.

3. Vorrichtung nach Anspruch 2,
dadurch gekennzeichnet, daß die Schwenkachse (34) des Rahmens (15), gesehen in dessen vor der Schwenkung eingenommenen Grundstellung, in der der Trogboden (23) horizontal angeordnet ist und der Trogmantel (24) nach oben weist, in vertikalem Abstand von der Tragplatte (17) oberhalb derselben und vorzugsweise oberhalb der Jochplatte (14) verlaufend angeordnet ist.

4. Vorrichtung nach Anspruch 2,
dadurch gekennzeichnet, daß die Schwenkachse (34) des Rahmens (15), gesehen in dessen vor der Schwenkung eingenommenen Grundstellung, in der der Trogboden (23) horizontal verlaufend angeordnet ist und der Trogmantel nach oben weist, unterhalb des Troges (22) und vorzugsweise in Höhe der Grundplatte (13) des Rahmens (15) angeordnet ist.

5. Vorrichtung nach Anspruch 3,
dadurch gekennzeichnet, daß die Schwenkachse (34) des Rahmens (15), gesehen in dessen vor der Schwenkung eingenommenen Grundstellung, in der der Trogboden (23) horizontal angeordnet ist und der Trogmantel (24) nach oben weist, in der Ebene der Innenfläche der Bodenplatte (23) des Troges (22) oder geringfügig oberhalb dieser innerhalb der Schichtdicke des Beschichtungsmaterial-Vorrates verläuft.

6. Vorrichtung nach einem der Ansprüche 2 bis 5,
dadurch gekennzeichnet, daß die Leiterplatte (11) an der der Tragplatte (17) abgewandten Seite der Jochplatte (14) an deren Öffnungsrändern abstützbar ist und mittels eines gegen die den Bauelementen abgewandte Lötseite der Leiterplatte (11) drängbaren und/oder an der Jochplatte (14) festlegbaren Zuhalteplatte (33) am Rahmen (15) fixierbar ist.

7. Vorrichtung nach Anspruch 6, **dadurch gekennzeich****net**, daß die Zuhalteplatte (33) an ihrer der Lötseite der Leiterplatte (11) zugewandten Seite mit einem mit dem Beschichtungsmaterial, insbesondere einem isolierenden Lack tränkbaren Druckkissen (38) versehen ist.

8. Vorrichtung nach Anspruch 7, **dadurch gekennzeich****net**, daß die Zuhalteplatte (33) um eine in seitlichem Abstand von einem Längsrand der Öffnung (31) der Jochplatte (14) und parallel zu dieser verlaufenden Achse (32) zwischen einer horizontalen Offenstellung und einer die Öffnung (31) überdeckenden Schließstellung schwenkbar ist.

9. Vorrichtung zum Aufbringen einer Kunststoffschicht auf eine mindestens einseitig mit elektronischen Bauelementen bestückte Leiterplatte, auf der auch mit solchen Bauelementen bestückte Bereiche vorhanden sind, die beschichtungsfrei zu halten sind, z.B. für Steckeranschlüsse und Relais, mit einem Trog, in den in flüssigem Zustand befindliches Beschichtungsmaterial einbringbar ist, mit dem die zu beschichtende(n) Fläche(n) der Leiterplatte in benetzenden Kontakt bringbar ist/sind, insbesondere zur Durchführung des Verfahrens nach Anspruch 1, **gekennzeichnet durch** die folgenden Merkmale:
a) Es ist ein an einer schwenkbaren Halterung sitzender Trogmantel vorgesehen, an den die Leiterplatte (11) von einer freien Seite her andrückbar ist, wobei die Leiterplatte (11) an dem Trogmantel fixierbar ist;
b) die am Trogmantel fixierte Leiterplatte (11) ist zusammen mit diesem in eine Position schwenkbar, in welcher von oben her Beschichtungsmaterial in diesen, durch den Mantel und die Leiterplatte (11) gebildeten, oben offenen Trog einfüllbar ist;
c) die Leiterplatte (11) ist aus einer nach dem Entleeren überschüssigen Beschichtungsmaterials aus dem Trog eingenommenen Position, in der sie an der Oberseite des nach unten offenen Trogmantels angeordnet ist, von dem Trogmantel abnehmbar.

## Claims

1. A process for applying a protective plastic film to a printed circuit board fitted with electronic components on at least one side, on which printed circuit board there are also areas which are fitted with such components and are to be kept free of film, for example for plug connections and relays, including a vat into which a coating material in a liquid state is introduced, with which coating material the surface(s) of the printed circuit board to be coatedare brought into a wetting contact, after which the wetted and surface-like coated printed circuit board is subjected to a drying operation during which the coating is hardened, characterised in that a vat wall (24) is provided which has exposed rims (26a to 26l) of its walls (25a to 25l) or wall sections shaped to correspond with the contour of the surface(s) to be coated and extending in a plane or surface which corresponds in shape with the plane or surface containing the contours of the surface(s) to be coated, that the side of the printed circuit board (11) which is to be partially coated is brought facing inwardly into abutment with the coplanar exposed rims (26a to 26l) and is held pressed on these rims corresponding with the shape of the coating surface(s), and the vat wall (24) and the printed circuit board (11) engaging it are thereafter moved into a position in which the printed circuit board (11) forms the lower base of the vat (22) and the coating material in the vat (22) can spread over the surfaces to be coated to wet same, that the vat (22) with the printed circuit board (11) still engaged is thereafter moved into a position in which the excess coating material drains off from the printed circuit board (11), and that the circuit board is thereafter removed and subjected to a drying or hardening operation.

2. An apparatus for applying a plastic film to a printed circuit board fitted with electronic components on at least one side, on which printed circuit board there are also areas which are fitted with components and are to be kept free of film, for example for plug connections and relays, comprising a vat into which can be introduced a coating material in a liquid state with which the surface(s) of the printed circuit board to be coated can be brought into a wetting contact, in particular for carrying out the process according to claim 1, characterised by the following characteristics:
a) The vat (22) includes a plate-shaped base part (23), from which project vertically vat wall sections (25a to 25l) and chimney wall sections (30a to 30d) of chimneys (28) for defining island-shaped areas (18) on the printed circuit board (11) that are to remain free of film;
b) the vat (22) can be fixed with its base plate (23) in a defined position on a support plate (17), which is part of the device and extends parallel to a base plate (13) and a yoke plate (14) which are spaced from one another and are connected fixedly with one another to form a frame (15), the support plate being arranged between these plates and being movable back and forth vertically with respect to these plates:
c) the yoke plate (14) has an opening (31) with edges on which the printed circuit board (11) can be fixed in a defined position with the side to be coated facing toward the vat (22) so that the contours of its surface(s) to be coated are arranged congruent with inner edges of the exposed rims (26a to 26l) of the wall sections (25a to 25l) forming the vat wall (24);
d) the frame (15) is supported pivotally about a horizontal axis (34) on a machine frame (36), with an angle of traverse, with reference to a base position of the frame (15) in which its base plate (13) extends horizontally and is below the support plate (17), being at least 180°.

3. An apparatus according to claim 2, characterised in that the pivot axis (34) of the frame (15), viewed ina base position prior to pivoting in which the vat base (23) is arranged horizontally and the vat wall (24) extends upwardly, is disposed at a vertical distance above the support plate (17) and preferably above the yoke plate (14).

4. An apparatus according to claim 2, characterised in that the pivot axis (34) of the frame (15), viewed in a position prior to pivoting in which the vat base (23) is arranged horizontally and the vat wall extends upwardly, is disposed below the vat (22) and preferably at the height of the base plate (13) of the frame (15).

5. An apparatus according to claim 3, characterised in that the pivot axis (34) of the frame (15), viewed in a base position prior to pivoting in which the vat base (23) is arranged horizontally and the vat wall (24) extends upwardly, extends in the plane of an inner surface of the base plate (23) of the vat (22) or slightly above same within the film thickness of the coating material supply.

6. An apparatus according to one of claims 2 to 5, characterised in that the printed circuit board (11) can be supported on a side of the yoke plate (14) which does not face the support plate (17) by opening edges of said yoke plate, and can be held on the frame (15) by a closing plate (33) that can be urged against the soldering side of the printed circuit board which does not face the components, and/or can be fixed on the yoke plate (14).

7. An apparatus according to claim 6, characterised in that the closing plate (33) has on its side facing the soldering side of the printed circuit board (11) a pressure cushion (38) which can be soaked with the coating material, in particular an insulating lacquer.

8. An apparatus according to claim 7, characterised in that the closing plate (33) can be pivoted about an axis (32) which is laterally spaced from a longitudinal edge of the opening (31) of the yoke plate (14) and extends parallel to same between a horizontal open position and a closed position covering the opening (31).

9. An apparatus for applying a plastic film to a printed circuit board fitted with electronic components on atleast one side, on which printed circuit board there are also areas which are fitted with components and are to be kept free of film, for example for plug connections and relays, comprising a vat into which can be introduced a coating material which is in a liquid state with which the surface(s) of the printed circuit board to be coated can be brought into a wetting contact, in particular for carrying out the process according to claim 1, characterised by the following characteristics:
a) a vat wall is provided on a pivotal mounting, on which vat wall can be pressed from a free side the printed circuit board (11), the printed circuit board (11) being fixable on the vat wall:
b) the printed circuit board (11) fixed on the vat wall can be pivoted together with same into a position in which the coating material can be supplied from above into the vat which is formed by the wall and the printed circuit board (11) and is open at the top;
c) the printed circuit board (11) can be removed from the vat wall from a position assumed after the excess coating material has been emptied out of the vat, in which position the printed circuit board is arranged on an upper side of the downwardly open vat wall.

## Revendications

1. Procédé de dépôt d'une couche protectrice en matière plastique sur une carte de circuits imprimés équipée de composants électroniques sur au moins l'une des faces qui présente également des zones équipées de tels composants qui ne doivent pas être revêtues, par exemple pour des connecteurs ou des relais, comprenant un bac dans lequel est introduite la matière de revêtement à l'état liquide avec laquelle la (les) surface(s) à revêtir de la carte de circuits imprimés doit (doivent) être mise(s) en contact mouillant, après quoi la carte de circuits imprimés ainsi mouillée et revêtue par zones est soumise à un processus de séchage au cours duquel le revêtement durcit, **caractérisé en ce** qu'il comprend la réalisation d'une chemise (24) du bac dont les surfaces frontales (26a à 26l) libres de ses parois (25a à 25l), et respectivement des sections de paroi de chemise, présentent une conformation qui correspond au contour de la (des) surface(s) à revêtir et s'étendent dans un plan ou une surface dont le contour correspond au plan ou à la surface dans lequel (laquelle) se situent les contours de la (des) surface(s) à revêtir, que la carte de circuits imprimés (11) est appliquée, avec la face à revêtir partiellement dirigée vers l'intérieur, contre les surfaces frontales libres (26a à 26l) orientées de manière coplanaire et maintenue en contact avec celles-ci suivant les contours de la (des) surface(s) à revêtir, que la chemise (24) du bac et la carte de circuits imprimés (11) posée sur celle-ci sont ensuite amenées dans une position dans laquelle la carte de circuits imprimés (11) forme le fond du bac (22) et dans laquelle la matière de revêtement introduite dans ledit bac (22) peut mouiller les surfaces à revêtir et s'épandre sur celles-ci, et que le bac (22) avec la carte de circuits imprimés (11) encore posée sur celui-ci, est ensuite amené dans une position dans laquelle la matière de revêtement en excédent s'écoule et s'égoutte de ladite carte de circuits imprimés (11) laquelle peut alors être enlevée et soumise au processus de séchage et respectivement de durcissement.

2. Dispositif de dépôt d'une couche de matière plastique sur une carte de circuits imprimés équipée de composants électroniques sur au moins l'une des faces laquelle comporte également des zones équipées de tels composants qui ne doivent pas être revêtues, par exemple pour des connecteurs et des relais, comprenant un bac dans lequel peut être introduite la matière de revêtement se trouvant à l'état liquide avec laquelle la (les) surface(s) à revêtir de la carte de circuits imprimés peut/peuvent être mise(s) en contact mouillant, en particulier pour la mise en oeuvre du procédé selon la revendication 1, **caractérisé en ce** qu'il présente les particularités suivantes :
a) Le bac (22) comprend un élément de fond (23) en forme de plaque sur lequel s'élèvent verticalement des sections de paroi de bac (25a à 25l) ainsi que des sections de cheminée (30a à 30d) de cheminées (28) prévues pour délimiter des plages (18) en forme d'îlots de la carte de circuits imprimés (11) dépourvues de revêtement;
b) le bac (22) qui peut être immobilisé avec sa plaque de fond (23) dans une position définie sur une plaque de support (17) faisant partie du dispositif et s'étend parallèlement à une plaque de base (13) et une plaque de culasse (14) lesquelles sont solidarisées, à distance l'une de l'autre, de manière à former un bâti (15), est disposé entre lesdites plaques et déplaçable dans les deux sens perpendiculairement par rapport à ces dernières;
c) la plaque de culasse (14) est munie d'une ouverture (31) sur les bords de laquelle la carte de circuits imprimés (11) peut être fixée dans une position définie, la surface à revêtir étant dirigée vers le bac (22), de telle façon que les contours de sa (ses) surface(s) à revêtir coïncident avec les bords intérieurs des surfaces frontales libres (26a à 26l) des sections de paroi de chemise (25a à 25l) qui forment la chemise (24) du bac;
d) le bâti (15) est monté sur un bâti de machine (36) de manière à pouvoir pivoter autour d'un axe horizontal (34), l'angle de pivotement, rapporté à une position de base du bâti (15) dans laquelle la plaque de base (13) de celui-ci est orientée horizontalement et disposée en dessous de la plaque de support (17), étant au moins égal à 180°.

3. Dispositif selon la revendication 2, caractérisé en ce que l'axe de pivotement (34) du bâti (15), vu dans la position de base de celui-ci avant le pivotement, dans laquelle le fond (23) du bac est orienté dans le sens horizontal et la chemise (24) du bac, dirigée vers le haut , se situe à distance verticale de la plaque de support (17), au-dessus de celle-ci, et de préférence au-dessus de la plaque de culasse (14).

4. Dispositif selon la revendication 2, caractérise en ce que l'axe de pivotement (34) du bâti (15), vu dans la position de base occupée par celui-ci avant le pivotement dans laquelle le fond (23) du bac est orienté horizontalement et la chemise du bac dirigée vers le haut, est disposé en dessous du bac (22) et de préférence au niveau de la plaque de base (13) du bâti (15).

5. Dispositif selon la revendication 3, caractérisé en ce que l'axe de pivotement (34) du bâti (15), vu dans la position de base occupée par celui-ci avant le pivotement dans laquelle le fond (23) du bac est orienté horizontalement et la chemise (24) du bac dirigée vers le haut, s'étend dans le plan de la surface intérieure de la plaque de fond (23) du bac (22) ou légèrement au-dessus de ce plan, à l'intérieur de l'épaisseur de couche de la réserve de matière de revêtement.

6. Dispositif selon l'une des revendications 2 à 5, caractérisé en ce que la carte de circuits imprimés (11) peut prendre appui du côté de la plaque de culasse (14) détourné de la plaque de support (17), sur les bords de l'ouverture de ladite plaque de culasse et qu'elle peut être immobilisée sur le bâti (15) au moyen d'une plaque de verrouillage (33) laquelle peut être poussée contre le côté brasage de la carte de circuits imprimés (11) détourné des composants et/ou bloquée sur la plaque de culasse (14).

7. Dispositif selon la revendication 6, caractérisé en ce que la plaque de verrouillage (33) est munie, sur sa face tournée vers le côté brasage de la carte de circuits imprimés (11), d'un tampon presseur (38) qui peut être imprégné avec la matière de revêtement, en particulier avec un vernis isolant.

8. Dispositif selon la revendication 7, caractérisé en ce que la plaque de verrouillage (33) peut pivoter autour d'un axe (32) qui s'étend à distance latérale de l'un des bords longitudinaux de l'ouverture (31) de la plaque de culasse (14) et parallèlement à cette dernière entre une position d'ouverture et une position de fermeture dans laquelle l'ouverture (31) est recouverte.

9. Dispositif de dépôt d'une couche de matière plastique sur une carte de circuits imprimés équipée sur au moins l'une des faces de composants électroniques laquelle comporte également des zones équipées de tels composants qui ne doivent pas être revêtues, par exemple pour des connecteurs et des relais, comprenant un bac dans lequel peut être introduite la matière de revêtement se trouvant à l'état liquide avec laquelle la (les) surface(s) à revêtir de la carte de circuits imprimés peut (peuvent) être mise(s) en contact mouillant, en particulier pour la mise en oeuvre du procédé selon la revendication 1, caractérisé en ce qu'il présente les particularités suivantes :
a) Il est prévu une chemise de bac montée sur un support pivotant et contre laquelle la carte de circuits imprimés (11) peut être appliquée à partir d'un côté libre, ladite carte de circuits imprimés (11) pouvant être immobilisée sur la chemise de bac;
b) la carte de circuits imprimés (11) immobilisée sur la chemise de bac peut être pivotée, conjointement avec ladite chemise, dans une position dans laquelle la matière de revêtement peut être versée par le haut dans ledit bac ouvert en haut et formé par la chemise et la carte de circuits imprimés (11);
c) la carte de circuits imprimés (11) peut être retirée de la chemise de bac dans une position que le bac occupe après l'évacuation de la matière de revêtement excédentaire, dans laquelle elle est disposée à la face supérieure de la chemise de bac ouverte vers le bas.
